# EUROPEAN PATENT APPLICATION

(11) **EP 1 702 968 A1**
(43) Date of publication of application: **20.09.2006**
(21) Application number: 05703338.3
(22) Date of filing: 06.01.2005
(51) Int. Cl.: C09J 201/00, H01R 11/01

(54) **CIRCUIT CONNECTION MATERIAL, FILM-SHAPED CIRCUIT CONNECTION MATERIAL USING THE SAME, CIRCUIT MEMBER CONNECTION STRUCTURE, AND MANUFACTURING METHOD THEREOF**

(30) Priority: 07.01.2004 JP 2004002305; 07.01.2004 JP 2004002308
(71) Applicant: Hitachi Chemical Company, Ltd., Shinjuku-ku, Tokyo 163-0449 (JP)
(72) Inventor: TAKETATSU, Jun; c/o Goshomiya Works, HITACHI, Chikusei-shi, Ibaraki; 308-8524 (JP); WATANABE, Itsuo; c/o Goshomiya Works, HITACHI, Chikusei-shi, Ibaraki;308-8524 (JP); GOTOU, Yasushi; c/o Goshomiya Works, HITACHI, Chikusei-shi, Ibaraki;308-8524 (JP); YAMAGUCHI, Kazuo; Advance Materials R & D Center, Chikusei-shi, Ibaraki;308-8521 (JP); FUJII, Masaki; c/o Goshomiya Works, HITACHI, Chikusei-shi, Ibaraki;308-8524 (JP); FUJII, Aya c/o Goshomiya Works; HITACHI CHEMICAL, Ibaraki 308-8524 (JP)
(74) Representative: Jönsson, Hans-Peter
(86) International application number: PCT/JP2005/000070
(87) International publication number: WO 2005/066298

(57) **Abstract**

A circuit member connection structure 10 according to the invention is provided with circuit members 20,30 having a plurality of circuit electrodes 22,32 formed on the main surfaces 21a,31a of circuit boards 21,31. A circuit connecting member 60 which connects together the circuit members 20,30 with the circuit electrodes 22,32 opposing each other is comprising a cured circuit connecting material of the invention. The circuit connecting material of the invention comprises an adhesive composition and covered particles 50 comprising conductive particles 51 with portions of their surfaces 51a covered by insulating fine particles 52, wherein the mass of the insulating fine particles 52 constitutes 2/1000 to 26/1000 of the mass of the conductive particles 51.

## Description

### Technical Field

The present invention relates to a circuit connecting material, a circuit connecting material film comprising it, and a circuit member connection structure and a process for its fabrication that employ it.

### Background Art

Glass panels for liquid crystal displays have liquid crystal driving ICs mounted thereon by COG (Chip-On-Glass) mounting or COF (Chip-On-Flex) mounting. In COG mounting, a circuit connecting material containing conductive particles is used for direct bonding of the liquid crystal driving IC onto the glass panel. In COF mounting, the liquid crystal driving IC is attached to flexible tape bearing a metal circuit, and a circuit connecting material containing conductive particles is used for bonding thereof to the glass panel.

However, with the increasingly higher definitions of liquid crystal displays in recent years, the gold bumps serving as circuit electrodes in liquid crystal driving ICs have narrower pitches and smaller areas, which causes the conductive particles in the circuit connecting material to leak out between adjacent circuit electrodes and thereby cause shorting problems. Also, leakage of the conductive particles between adjacent circuit electrodes reduces the number of conductive particles in the circuit connecting material held between the gold bumps and glass panel, such that the electrical resistance between opposing circuit electrodes increases and results in poor connection problems.

This has spurred the development of methods for solving such problems, such as a method of preventing reduced bonding quality in COG mounting or COF mounting by formation of an insulating adhesive layer on at least one side of the circuit connecting material (see Patent document 1, for example), or a method of covering the entire surfaces of the conductive particles with an insulating coating (see Patent document 2, for example).
[Patent document 1] Japanese Unexamined Patent Publication No. H8-279371
[Patent document 2] Japanese Patent Publication No. 2794009 (Fig. 2).

### Disclosure of the Invention

### Problems to be Solved by the Invention

However, in methods of forming an insulating adhesive layer on one side of a circuit connecting member when the bump area is less than 3000 µm² and the number of conductive particles is increased to obtain stable connection resistance, the resulting insulating property between adjacent circuit electrodes is still not fully satisfactory. In methods of covering the entire surfaces of the conductive particles with an insulating coating, a problem of increased connection resistance between opposing circuit electrodes occurs, making it impossible to obtain stable electrical resistance.

It is therefore an object of the present invention to provide a circuit connecting material that can adequately reduce connection resistance between opposing circuit electrodes and satisfactorily improve the insulation property between adjacent circuit electrodes, as well as a circuit connecting material film comprising it and a circuit member connection structure and a process for its fabrication that employ it.

### Means for Solving the Problems

In order to achieve the object stated above, the circuit connecting material of the invention is provided as a circuit connecting material for connection of a first circuit member having a plurality of first circuit electrodes formed on the main surface of a first circuit board and a second circuit member having a plurality of second circuit electrodes formed on the main surface of a second circuit board, with the first and second circuit electrodes opposing each other, the circuit connecting material comprising an adhesive composition and covered particles comprising conductive particles with portions of their surfaces covered by insulating fine particles, wherein the mass of the insulating fine particles constitutes 2/1000 to 26/1000 of the mass of the conductive particles.

When the connection structure of the circuit member is obtained by situating the circuit connecting material between the first and second circuit members and heating and pressing it through the first and second circuit members for curing treatment, the obtained circuit member connection structure has adequately reduced connection resistance between the opposing circuit electrodes and satisfactorily improved insulation between adjacent circuit electrodes.

If the mass of the insulating fine particles is less than 2/1000 of the mass of the conductive particles, the conductive particles will not be adequately covered by the insulating fine particles. The insulating property between adjacent circuit electrodes, i.e. the insulating property in the plane of the circuit boards, will therefore be unsatisfactory. On the other hand, if the mass of the insulating fine particles exceeds 26/1000 of the mass of the conductive particles, the insulating fine particles will be excessively covering the conductive particles. This will result in increased connection resistance of the conductive particles in the thickness direction of the circuit board when opposing circuit electrodes are connected together.

The circuit connecting material of the invention is also provided as a circuit connecting material for connection of a first circuit member having a plurality of first circuit electrodes formed on the main surface of a first circuit board and a second circuit member having a plurality of second circuit electrodes formed on the main surface of a second circuit board, with the first and second circuit electrodes opposing each other, the circuit connecting material comprising an adhesive composition and covered particles comprising conductive particles with portions of their surfaces covered by insulating fine particles, wherein the conductive particles have nuclei comprising a polymer, and the mass of the insulating fine particles constitutes 7/1000 to 86/1000 of the mass of the nuclei.

When the connection structure of the circuit member is obtained by situating this circuit connecting material between the first and second circuit members and heating and pressing it through the first and second circuit members for curing treatment, the obtained circuit member connection structure has adequately reduced connection resistance between the opposing circuit electrodes and satisfactorily improved insulation between adjacent circuit electrodes.

If the mass of the insulating fine particles is less than 7/1000 of the mass of the nuclei, the conductive particles will not be adequately covered by the insulating fine particles. The insulating property between adjacent circuit electrodes, i.e. the insulating property in the plane of the circuit boards, will therefore be unsatisfactory. On the other hand, if the mass of the insulating fine particles exceeds 86/1000 of the mass of the nuclei, the insulating fine particles will be excessively covering the conductive particles. This will result in increased connection resistance of the conductive particles in the thickness direction of the circuit board when opposing circuit electrodes are connected together.

The circuit connecting material of the invention is also provided as a circuit connecting material for connection of a first circuit member having a plurality of first circuit electrodes formed on the main surface of a first circuit board and a second circuit member having a plurality of second circuit electrodes formed on the main surface of a second circuit board, with the first and second circuit electrodes opposing each other, the circuit connecting material comprising an adhesive composition and covered particles comprising conductive particles with portions of their surfaces covered by insulating fine particles, wherein the specific gravity of the covered particles is 97/100 to 99/100 of the specific gravity of the conductive particles.

When the connection structure of the circuit member is obtained by situating this circuit connecting material between the first and second circuit members and heating and pressing it through the first and second circuit members for curing treatment, the obtained circuit member connection structure has adequately reduced connection resistance between the opposing circuit electrodes and satisfactorily improved insulation between adjacent circuit electrodes.

If the specific gravity of the covered particles is less than 97/100 of the specific gravity of the conductive particles, the insulating fine particles will be excessively covering the conductive particles. This will result in increased connection resistance of the conductive particles in the thickness direction of the circuit board when opposing circuit electrodes are connected together. On the other hand, if the specific gravity of the covered particles is greater than 99/100 of the specific gravity of the conductive particles, the conductive particles will not be adequately covered by the insulating fine particles. The insulating property between adjacent circuit electrodes, i.e. the insulating property in the plane of the circuit boards, will therefore be unsatisfactory.

In the covered particles, it is preferred for 5 to 60% of the surfaces of the conductive particles to be covered by the insulating fine particles.

If less than 5% of the surfaces of the conductive particles is covered, the conductive particles will not be adequately covered by the insulating fine particles, and the insulating property between adjacent circuit electrodes, i.e. the insulating property in the plane of the circuit boards, will therefore be unsatisfactory as compared to when no less than 5% of the surfaces is covered. On the other hand, if more than 60% of the surfaces of the conductive particles is covered the insulating fine particles will be excessively covering the conductive particles, and therefore electrical resistance in the thickness direction of the circuit boards will be increased when the opposing circuit electrodes are connected together, as compared to when not greater than 60% of the surfaces of the conductive particles is covered.

The mean particle size of the insulating fine particles is preferably 1/40 to 1/10 of the mean particle size of the conductive particles.

If the mean particle size of the insulating fine particles is within this range, the surfaces of the conductive particles will be more readily covered by the insulating fine particles than if the mean particle size is outside of the range, and therefore using such a circuit connecting material for fabrication of a circuit member connection structure will result in further improved insulation between adjacent circuit electrodes, i.e. insulation in the plane of the circuit boards.

Also, the insulating fine particles are preferably comprising a polymer of a radical polymerizing substance. In this case, the insulating fine particles will readily adhere to the surfaces of the conductive particles, and therefore using such a circuit connecting material for fabrication of a circuit member connection structure will result in further improved insulation between adjacent circuit electrodes, i.e. insulation in the plane of the circuit boards.

The adhesive composition preferably comprises a radical polymerizing substance and a curing agent which generates free radicals in response to heating. A circuit connecting material containing such an adhesive composition will facilitate connection between the first and second circuit members during heating.

The circuit connecting material preferably also comprises a film-forming material comprising a phenoxy resin. This will permit working of the circuit connecting material into a film form. It will also help prevent problems such as tearing, cracking or sticking of the circuit connecting material, and thus facilitate handling of the circuit connecting material.

The phenoxy resin preferably has a molecular structure derived from a polycyclic aromatic compound in the molecule. This will yield a circuit connecting material with excellent adhesion, compatibility, heat resistance and mechanical strength and so on.

The polycyclic aromatic compound is preferably fluorene.

The circuit connecting material film of the invention is obtained by forming the circuit connecting material of the invention into a film. This will help to prevent problems such as tearing, cracking or sticking of the circuit connecting material, and thus facilitate handling of the circuit connecting material.

The circuit member connection structure of the invention is a circuit member connection structure provided with a first circuit member having a plurality of first circuit electrodes formed on the main surface of a first circuit board, a second circuit member having a plurality of second circuit electrodes formed on the main surface of a second circuit board, and a circuit connecting member situated between the main surface of the first circuit board and the main surface of the second circuit board, and connecting the first and second circuit members together with the first and second circuit electrodes opposing each other, wherein the circuit connecting member is comprising a cured circuit connecting material of the invention and the first circuit electrodes and the second circuit electrodes are electrically connected through covered particles.

This type of circuit member connection structure allows adequate reduction in the connection resistance between the opposing circuit electrodes, while also satisfactorily improving insulation between adjacent circuit electrodes.

When a direct current voltage of 50 V is applied between adjacent circuit electrodes, the resistance value between the adjacent circuit electrodes is preferably 10⁹ Ω or greater.

Because insulation between adjacent circuit electrodes, i.e. insulation in the plane of the circuit boards is extremely high during operation with this circuit member connection structure, it is possible to adequately prevent shorts between adjacent circuit electrodes.

Either or both of the first and second circuit members is preferably an IC chip.

Also, the connection resistance between the first circuit electrodes and the second circuit electrodes is preferably no greater than 1 Ω. In this type of circuit member connection structure, connection resistance between opposing circuit electrodes, i.e. connection resistance in the thickness direction of the circuit board, is satisfactorily reduced.

Either or both of the first and second circuit electrodes of this circuit member connection structure also preferably comprises an electrode surface layer comprising at least one compound selected from the group comprising gold, silver, tin, platinum group metals and indium tin oxide.

Also, either or both of the first and second circuit members of this circuit member connection structure also preferably comprises a board surface layer comprising at least one compound selected from the group comprising silicon nitride, silicone compounds and polyimide resins. This will further improve the adhesive strength between the circuit members and circuit connecting member, compared to when the board surface layer does not comprise one of the aforementioned materials.

The process for fabrication of a circuit member connection structure according to the invention comprises: a step of situating a circuit connecting material of the invention between a first circuit member having a plurality of first circuit electrodes formed on the main surface of a first circuit board and a second circuit member having a plurality of second circuit electrodes formed on the main surface of a second circuit board, with the first circuit electrode and second circuit electrode opposing each other; and a step of curing the circuit connecting material by heating and pressing.

By using this fabrication process it is possible to obtain a circuit member connection structure with satisfactorily reduced connection resistance between opposing circuit electrodes and adequately improved insulation between adjacent circuit electrodes.

### Effect of the Invention

According to the invention, it is possible to provide a circuit connecting material which can stably produce low-resistance electrical connections between opposing circuit electrodes in COG mounting or COF mounting and inhibit shorting between adjacent circuit electrodes, as well as a circuit connecting material film comprising it and a circuit member connection structure and a process for their fabrication that employ it.

According to the invention it is also possible to provide a circuit connecting material with high connection reliability even in driving ICs with narrow distances between adjacent circuit electrodes, i.e. between bumps, as well as a circuit connecting material film comprising it and a circuit member connection structure and a process for their fabrication that employ it.

### Brief Description of the Drawings

Fig. 1 is a cross-sectional view showing an embodiment of a circuit member connection structure according to the invention.
Fig. 2 is a cross-sectional view showing an example of a covered particle used in a circuit connecting material according to the invention.
Fig. 3 is a cross-sectional view showing an embodiment of a circuit connecting material film according to the invention.
Fig. 4 is a cross-sectional view showing a step in a fabrication process for a circuit member connection structure according to the invention.
Fig. 5 is a graph showing a calibration curve for determining the mass ratio A in Examples 1 and 2 of the invention and Comparative Example 2.
Fig. 6 is a graph showing a calibration curve for determining the mass ratio B in Examples 1 and 2 of the invention and Comparative Example 2.
Fig. 7 is a graph showing a calibration curve for determining the mass ratio A in Example 3 of the invention.
Fig. 8 is a graph showing a calibration curve for determining the mass ratio B in Example 3 of the invention.
Fig. 9 is a pyrogram obtained as a result of pyrolysis gas chromatography measurement of the covered particles C in Example 3 of the invention.

### Explanation of Symbols

10: Circuit member connection structure, 20: circuit member (first circuit member), 21: circuit board (first circuit board), 21a: main surface, 22: circuit electrode (first circuit electrode), 24,24: electrode surface layers, 30: circuit member (second circuit member), 31: circuit board (second circuit board), 31a: main surface, 32: circuit electrode (second circuit electrode), 35: board surface layer, 50: covered particles, 51: conductive particles, 51x: nucleus, 51y: outer layer, 51a: surface, 52: insulating fine particles, 60: circuit connecting member, 61: circuit connecting material film.

### Best Modes for Carrying Out the Invention

Preferred embodiments of the circuit connecting material, circuit connecting material film comprising it, circuit member connection structure and process for their fabrication according to the invention will now be explained. Throughout the drawings, corresponding elements will be referred to by like reference numerals and will be explained only once.

### [First embodiment]

### (Circuit member connection structure)

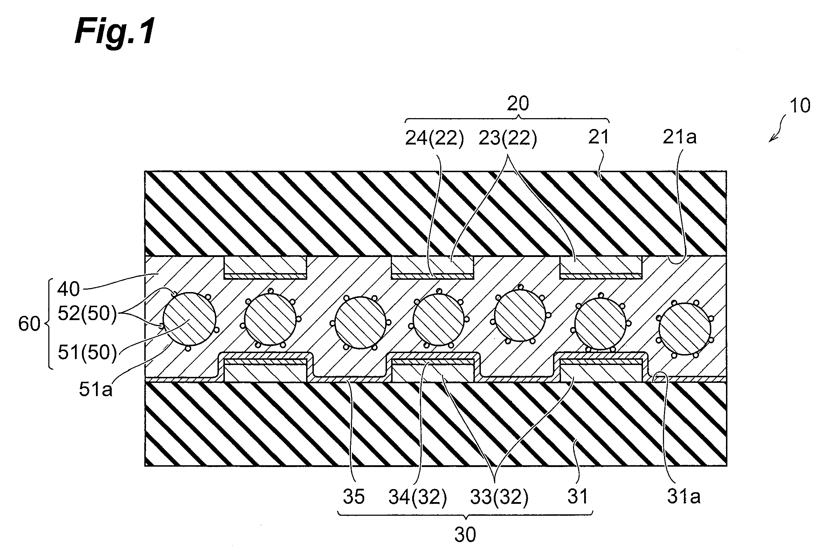

Fig. 1 is a cross-sectional view showing a first embodiment of a circuit member connection structure (hereinafter referred to as "connection structure") according to the invention. The connection structure 10 of this embodiment is provided with a circuit member 20 (first circuit member) and a circuit member 30 (second circuit member) which are mutually opposing, with a circuit connecting member 60 connecting between the circuit member 20 and circuit member 30.

The circuit member 20 is provided with a circuit board 21 (first circuit board) and a plurality of circuit electrodes 22 (first circuit electrodes) formed on the main surface 21a of the circuit board 21. The plurality of circuit electrodes 22 are arranged, for example, in a stripe fashion. Also, the circuit member 30 is provided with a circuit board 31 (second circuit board) and a plurality of circuit electrodes 32 (second circuit electrodes) formed on the main surface 31a of the circuit board 31. The plurality of circuit electrodes 32 are also arranged, for example, in a stripe fashion.

As specific examples of circuit members 20,30 there may be mentioned chip parts such as semiconductor chips, resistor chips or condenser chips, or boards such as printed boards. The manner of connection of the connection structure 10 may be connection between an IC chip and a chip-mounting board, connection between electrical circuits, or connection between an COF-mounted or COF-mounted IC chip and a glass panel or flexible tape.

Most preferably, at least one of the circuit members 20,30 is an IC chip.

The circuit electrode 22 is constructed of an electrode portion 23 formed on the main surface 21 a of the circuit board 21 and an electrode surface layer 24 formed on the electrode portion 23. The circuit electrode 32 is likewise constructed of an electrode portion 33 formed on the main surface 31a of the circuit board 31 and an electrode surface layer 34 formed on the electrode portion 33. Here, each of the electrode surface layers 24,34 is preferably comprising gold, silver, tin, a platinum group metal or indium tin oxide (ITO), or a combination of two or more thereof. That is, the circuit electrodes 22,32 preferably each have an electrode surface layer 24,34 comprising gold, silver, tin, a platinum group metal or indium tin oxide (ITO), or a combination of two or more thereof, on the electrode portion 23,33.

The circuit member 30 has a board surface layer 35 on the circuit board 31 and circuit electrode 32. Here, the board surface layer 35 is preferably comprising silicon nitride, a silicone compound or a polyimide resin, or a combination of two or more thereof. That is, the circuit member 30 preferably has a board surface layer 35 comprising silicon nitride, a silicone compound or a polyimide resin, or a combination of two or more thereof. The board surface layer 35 is either coated on the circuit board 31 and circuit electrode 32 or is attached to the circuit board 31 and circuit electrode 32. The board surface layer 35 improves the adhesive strength between the circuit member 30 and the circuit connecting member 60.

When the circuit member 30 or circuit board 31 is a flexible tape, the board surface layer 35 is preferably comprising an organic insulating substance such as a polyimide resin. When the circuit board 31 is a glass panel, the board surface layer 35 is preferably comprising silicon nitride, a silicone compound, a polyimide resin or a silicone resin, or a combination of two or more thereof.

The circuit connecting member 60 is situated between the main surface 21a of the circuit board 21 and the main surface 31a of the circuit board 31, and it connects together the circuit members 20,30 with the circuit electrodes 22,32 opposing each other. The circuit connecting member 60 is also provided with an insulating member 40 and covered particles 50. The covered particles 50 serve for electrical connection between the circuit electrode 22 and circuit electrode 32, and comprise conductive particles 51 and insulating fine particles 52 covering portions of the surfaces 51a of the conductive particles 51. In this embodiment, the mass of the insulating fine particles 52 constitutes 2/1000 to 26/1000 of the mass of the conductive particles 51.

With this type of connection structure 10, the connection resistance between the opposing circuit electrodes 22,32 is adequately reduced and stabilized, while the insulating property between adjacent circuit electrodes 22,32 is satisfactorily improved.

If the mass of the insulating fine particles 52 is less than 2/1000 of the mass of the conductive particles 51, the conductive particles 51 will not be adequately covered by the insulating fine particles 52. The insulating property between adjacent circuit electrodes 22,32, i.e. the insulating property in the plane of the circuit boards 21,31, will therefore be unsatisfactory. On the other hand, if the mass of the insulating fine particles 52 exceeds 26/1000 of the mass of the conductive particles 51, the insulating fine particles 52 will be excessively covering the conductive particles 51. This will result in increased connection resistance of the conductive particles 51 in the thickness direction of the circuit boards 21,31 when the opposing circuit electrodes 22,32 are connected together.

In regard to the insulating property between the adjacent circuit electrodes 22,32, this connection structure 10 preferably has a resistance value between the adjacent circuit electrodes 22,32 of 10⁹ Ω or greater when a direct current voltage of 50 V is applied between adjacent circuit electrodes 22,32. Because the insulating property between the adjacent circuit electrodes 22,32, i.e. the insulating property in the plane of the circuit boards 21,31 is extremely high during operation with this circuit member connection structure 10, it is possible to adequately prevent shorts between the adjacent circuit electrodes 22,32.

In regard to the connection resistance between the opposing circuit electrodes 22,32, this connection structure 10 preferably has a connection resistance between the circuit electrodes 22 and circuit electrodes 32 of no greater than 1 Ω. In this manner of connection structure 10, the connection resistance between the opposing circuit electrodes 22,32, i.e. the connection resistance in the thickness direction of the circuit boards 21,31, can be satisfactorily reduced.

For the covered particles 50, the mean particle size dᵢ of the insulating fine particles 52 is preferably 1/40 to 1/10 of the mean particle size d_{c} of the conductive particles 51. The mean particle sizes dᵢ and d_{c} are the average values of those obtained by measuring the long axes of the insulating fine particles 52 and the conductive particles 51 observed under various types of microscopes, upon measurement of ten or more particles each. The microscope used for observation is preferably a scanning electron microscope.

If the mean particle size dᵢ of the insulating fine particles 52 is within this range, the surfaces 51a of the conductive particles 51 will be more readily covered by the insulating fine particles 52 than if the mean particle size dᵢ is outside of the range, and therefore this manner of connection structure 10 will result in a further improved insulating property between the adjacent circuit electrodes 22,32, i.e. insulating property in the plane of the circuit boards 21,31.

As conductive particles 51 there may be mentioned metal particles made of Au, Ag, Ni, Cu or solder, or carbon particles. The conductive particles 51 are preferably heat-fusible metal particles. This will allow the conductive particles 51 to readily deform under heating and pressure during connection between the circuit electrodes 22,32, and therefore the contact area between the conductive particles 51 and the circuit electrodes 22,32 will be increased for enhanced connection reliability.

The insulating fine particles 52 are preferably comprising a polymer of a radical polymerizing substance. This will facilitate attachment of the insulating fine particles 52 to the surfaces 51a of the conductive particles 51, so that in this manner of connection structure 10, the insulating property between the adjacent circuit electrodes 22,32, i.e. the insulating property in the plane of the circuit boards 21,31, can be further improved.

Radical polymerizing substances are substances having a functional group that polymerizes by radicals, and as such radical polymerizing substances there may be mentioned acrylates (including corresponding methacrylates, same hereunder) compounds and maleimide compounds. The radical polymerizing substance used may be a monomer or oligomer, or a monomer and oligomer may be used in combination.

As specific examples of acrylate compounds there may be mentioned methyl acrylate, ethyl acrylate, isopropyl acrylate, isobutyl acrylate, ethyleneglycol diacrylate, diethyleneglycol diacrylate, trimethylolpropane triacrylate, tetramethylolmethylolmethane tetraacrylate, 2-hydroxy-1,3-diacryloxypropane, 2,2-bis[4-(acryloxymethoxy)phenyl]propane, 2,2-bis[4-(acryloxypolyethoxy)phenyl]propane, dicyclopentenyl acrylate, tricyclodecanyl acrylate, tris(acryloyloxyethyl) isocyanurate and urethane acrylate. These may be used alone or in mixtures of two or more. If necessary, a polymerization inhibitor such as a hydroquinone or methyletherhydroquinone may be used as well. From the viewpoint of improving heat resistance, the acrylate compound preferably has at least one substituent selected from the group comprising dicyclopentenyl groups, tricyclodecanyl groups and triazine rings.

Maleimide compounds contain two or more maleimide groups in the molecule. As examples of such maleimide compounds there may be mentioned 1-methyl-2,4-bismaleimidebenzene, N,N'-m-phenylenebismaleimide, N,N'-p-phenylenebismaleimide, N,N'-m-tolylenebismaleimide, N,N'-4,4-biphenylenebismaleimide, N,N'-4,4-(3,3'-dimethylbiphenylene)bismaleimide, N,N'-4,4-(3,3'-dimethyldiphenylmethane)bismaleimide, N,N'-4,4-(3,3'-diethyldiphenylmethane)bismaleimide, N,N'-4,4-diphenylmethanebismaleimide, N,N'-4,4-diphenylpropanebismaleimide, N,N'-3,3'-diphenylsulfonebismaleimide, N,N'-4,4-diphenyletherbismaleimide, 2,2-bis(4-(4-maleimidephenoxy)phenyl)propane, 2,2-bis(3-s-butyl-4,8-(4-maleimidephenoxy)phenyl)propane, 1,1-bis(4-(4-maleimidephenoxy)phenyl)decane, 4,4'-cyclohexylidene-bis(1-(4-maleimidephenoxy)-2-cyclohexylbenzene and 2,2-bis(4-(4-maleimidephenoxy)phenyl)hexafluoropropane. These may be used alone or in mixtures of two or more.

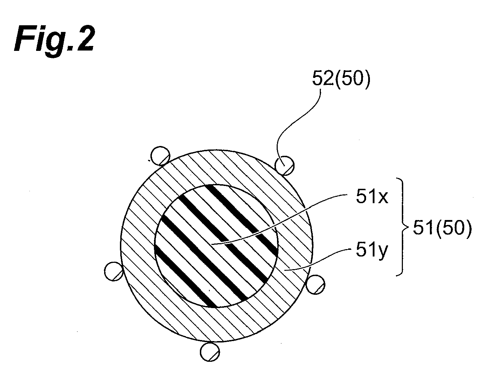

Also, as shown in Fig. 2, the conductive particles 51 may possess a nucleus 51x and an outer layer 51y formed covering the surface of the nucleus 51x. Fig. 2 is a cross-sectional view showing an example of a covered particle. The conductive particles 51 of Fig. 1 may be replaced by conductive particles 51 of the type shown in Fig. 2.

The nucleus 51x is comprising a polymer, and preferred polymers include various types of plastics such as polystyrene, polydivinylbenzene, polyacrylic acid esters, epoxy resins, phenol resins and benzoguanamine resins, and various types of rubber compounds such as styrene-butadiene rubber and silicone rubber. With these as the major components, there may also be added various types of additives such as crosslinking agents, curing agents and age inhibitors. In this case, the conductive particles 51 will readily deform under heating and pressure during connection between the circuit electrodes 22,32, and therefore the contact area between the conductive particles 51 and the circuit electrodes 22,32 will be increased for enhanced connection reliability.

In this embodiment, the mass of the insulating fine particles 52 constitutes 7/1000 to 86/1000 of the mass of the nuclei 51x. If the mass of the insulating fine particles 52 is less than 7/1000 of the mass of the nuclei 51x, the conductive particles 51 will not be adequately covered by the insulating fine particles 52. The insulating property between adjacent circuit electrodes 22,32, i.e. the insulating property in the plane of the circuit boards 21,31, will therefore be unsatisfactory. On the other hand, if the mass of the insulating fine particles 52 exceeds 86/1000 of the mass of the nuclei 51x, the insulating fine particles 52 will be excessively covering the conductive particles 51. This will result in increased connection resistance of the conductive particles 51 in the thickness direction of the circuit boards 21,31 when the opposing circuit electrodes 22,32 are connected together.

The nuclei 51x may also be comprising non-conductive glass, ceramic, plastic or the like. In this case as well, the conductive particles 51 will readily deform under heating and pressure during connection between the circuit electrodes 22,32, and therefore the contact area between the conductive particles 51 and the circuit electrodes 22,32 will be increased for enhanced connection reliability. Also, the conductive particles 51 preferably have an outer layer 51y made of a precious metal formed on the surface of the nucleus 51x made of non-conductive glass, ceramic, plastic or the like.

In order to achieve an adequate pot life (usable life), the outer layer 51y is preferably not comprising a transition metal such as Ni or Cu, but rather of a precious metal such as Au, Ag or a platinum group metal, and more preferably of Au. The conductive particles 51 may also have the nucleus 51 x made of a transition metal such as Ni covered by the outer layer 51y made of a precious metal such as Au.

The thickness of the precious metal outer layer 51y is preferably at least 100 angstroms. This will result in satisfactory connection resistance between the circuit electrodes 22,32. When a precious metal outer layer 51y is formed on the surface of a nucleus 51x comprising a transition metal such as Ni, the thickness of the precious metal outer layer 51y is preferably at least 300 angstroms. If the thickness of the precious metal outer layer 51y is less than 300 angstroms, defects may occur in the outer layer 51y during mixing dispersion of the conductive particles 51, for example. Free radicals can form due to oxidation-reduction reaction at such defect sites, thereby lowering the shelf life of the circuit connecting material. A large thickness of the outer layer 51y will saturate the effect of the outer layer 51y, and therefore the thickness of the outer layer 51 is preferably no greater than 1 micrometer.

The value of the ratio of the mass of the insulating fine particles 52 with respect to the mass of the conductive particles 51 (mass ratio A) and the value of the ratio of the mass of the insulating fine particles 52 with respect to the mass of the nuclei 51x (mass ratio B) according to the invention are the values measured by pyrolysis gas chromatography. Pyrolysis gas chromatography is commonly used for qualitative analysis of various plastic and rubber materials, and for compositional assay of their copolymers and blends (see Samukawa, K., Oguri, N., "Introduction to Pyrolysis Gas Chromatography", P121-P 176, Gihodo Publishing).

The present inventors have discovered that using pyrolysis gas chromatography as the method for measuring the values for the mass ratio A and mass ratio B can result in satisfactory quantitation. According to the invention, therefore, the values used for the mass ratio A and mass ratio B may be determined by the pyrolysis gas chromatography calibration curve method. The calibration curve used in this case is not limited to a calibration curve drawn using the same material as the conductive particles, the same material as the nuclei 51x or the same material as the insulating fine particles 52. It may be a calibration curve drawn using instead a polymer of the same type of plastic, rubber or radical-polymerizing substance.

The peaks in pyrolysis gas chromatography used for measurement of the values of the mass ratio A and mass ratio B are not particularly restricted and may be the peaks for the thermal decomposition products from the conductive particles 51, nuclei 51x and insulating fine particles 52. Such thermal decomposition products are preferably the thermal decomposition products of the primary monomers composing the plastic, rubber or radical polymerizing substances, since their peaks will give better quantitation for the values of the mass ratio A and mass ratio B.

### (Circuit connecting material)

The circuit connecting member 60 is comprising a cured product of the circuit connecting material. The circuit connecting material will now be explained. The circuit connecting material contains covered particles and an adhesive composition. As described hereunder, the circuit connecting material may also further contain a film-forming material and other components.

### <Covered particles>

The covered particles in the circuit connecting material have the same construction as the aforementioned covered particles 50. The conductive particles 51 of the covered particles 50 are preferably added at 0.1 to 30 parts by volume with respect to 100 parts by volume of the adhesive composition. The exact amount of addition may be determined depending on the purpose of use. In order to prevent shorting between the adjacent circuit electrodes due to excessive conductive particles 51, it is more preferred to add the conductive particles 51 at 0.1 to 10 parts by volume.

### <Adhesive composition>

The adhesive composition preferably comprises a radical polymerizing substance and a curing agent which generates free radicals in response to heating. A circuit connecting material containing such an adhesive composition will facilitate connection between the circuit members 20,30 during heating.

Examples of radical polymerizing substances include the same radical polymerizing substances used for the insulating fine particles 52. The radical polymerizing substance used may be a monomer or oligomer, or a monomer and oligomer may be used in combination.

The curing agent which generates free radicals upon heating is a curing agent that generates free radicals by decomposition upon heating. As such curing agents there may be mentioned peroxide compounds and azo-based compounds. Such curing agents may be appropriately selected as appropriate for the desired connection temperature, connection time and pot life. In order to increase the reactivity and allow an improved pot life to be achieved, it is preferred to use an organic peroxide with a 10 hour half-life temperature of 40°C or higher and a 1 minute half-life temperature of no higher than 180°C, and it is more preferred to use an organic peroxide with a 10 hour half-life temperature of 60°C or higher and a 1 minute half-life temperature of no higher than 170°C.

In order to achieve adequate reactivity when the connection time is 10 seconds or shorter, the content of the curing agent is preferably 0.1 to 30 parts by weight and more preferably 1 to 20 parts by weight with respect to the total of 100 parts by weight of the radical polymerizing substance and the film-forming material included as necessary.

If the curing agent content is less than 0.1 part by weight it will not be possible to achieve sufficient reactivity, and satisfactory adhesive strength or low connection resistance may not be obtainable. If the curing agent content exceeds 30 parts by weight, the flow property of the adhesive composition may be reduced, the connection resistance may be increased, and the pot life of the adhesive composition may be shortened.

More specifically, as curing agents that generate free radicals upon heating there may be mentioned diacyl peroxides, peroxy dicarbonates, peroxy esters, peroxy ketals, dialkyl peroxides, hydroperoxides and silyl peroxides. From the viewpoint of inhibiting corrosion of the circuit electrodes 22,32, the curing agent preferably has a chloride ion or organic acid concentration of no greater than 5000 ppm, and more preferably the content of organic acids generated after thermal decomposition is low. Specifically, such curing agents may be selected from among peroxy esters, dialkyl peroxides, hydroperoxides and silyl peroxides, and preferably are selected from among peroxy esters with high reactivity. These curing agents may also be used in appropriate mixtures.

As diacyl peroxides there may be mentioned isobutyl peroxide, 2,4-dichlorobenzoyl peroxide, 3,5,5-trimethylhexanoyl peroxide, octanoyl peroxide, lauroyl peroxide, stearoyl peroxide, succinic peroxide, benzoylperoxytoluene and benzoyl peroxide.

As peroxydicarbonates there may be mentioned di-n-propyl peroxydicarbonate, diisopropyl peroxydicarbonate, bis(4-t-butylcyclohexyl) peroxydicarbonate, di-2-ethoxymethoxy peroxydicarbonate, di(2-ethylhexylperoxy) dicarbonate, dimethoxybutyl peroxydicarbonate and di(3-methyl-3methoxybutylperoxy) dicarbonate.

As peroxyesters there may be mentioned cumyl peroxyneodecanoate, 1,1,3,3-tetramethylbutyl peroxyneodecanoate, 1-cyclohexyl-1-methylethyl peroxyneodecanoate, t-hexylperoxyneodecanoate, t-butyl peroxypivalate, 1,1,3,3-tetramethylbutyl peroxy-2-ethylhexanonate, 2,5-dimethyl-2,5-di(2-ethylhexanoylperoxy)hexane, 1-cyclohexyl-1-methylethyl peroxy-2-ethylhexanonate, t-hexyl peroxy-2-ethylhexanonate, t-butyl peroxy-2-ethylhexanonate, t-butyl peroxyisobutyrate, 1,1-bis(t-butylperoxy)cyclohexane, t-hexyl peroxyisopropylmonocarbonate, t-butyl peroxy-3,5,5-trimethylhexanonate, t-butyl peroxylaurate, 2,5-dimethyl-2,5-di(m-toluoylperoxy)hexane, t-butyl peroxyisopropylmonocarbonate, t-butyl peroxy-2-ethylhexylmonocarbonate, t-hexyl peroxybenzoate and t-butyl peroxyacetate.

As peroxyketals there may be mentioned 1,1-bis(t-hexylperoxy)-3,3,5-trimethylcyclohexane, 1,1-bis(t-hexylperoxy)cyclohexane, 1,1-bis(t-butylperoxy)-3,3,5-trimethylcyclohexane, 1,1-(t-butylperoxy)cyclododecane and 2,2-bis(t-butylperoxy)decane.

As dialkyl peroxides there may be mentioned α,α'-bis(t-butylperoxy)diisopropylbenzene, dicumyl peroxide, 2,5-dimethyl-2,5-di(t-butylperoxy)hexane and t-butylcumyl peroxide.

As hydroperoxides there may be mentioned diisopropylbenzene hydroperoxide and cumene hydroperoxide.

As silyl peroxides there may be mentioned t-butyltrimethylsilyl peroxide, bis(t-butyl)dimethylsilyl peroxide, t-butyltrivinylsilyl peroxide, bis(t-butyl)divinylsilyl peroxide, tris(t-butyl)vinylsilyl peroxide, t-butyltriallylsilyl peroxide, bis(t-butyl)diallylsilyl peroxide and tris(t-butyl)allylsilyl peroxide.

These curing agents may be used alone or in combinations of two or more, and may also be used in admixture with triggers or inhibitors. These curing agents are also preferably coated with a polyurethane-based or polyester-based polymer substance and made into microcapsules for an extended pot life.

The circuit connecting material preferably also comprises a film-forming material comprising a phenoxy resin. This will permit working of the circuit connecting material into a film form, in order to obtain a circuit connecting material film.

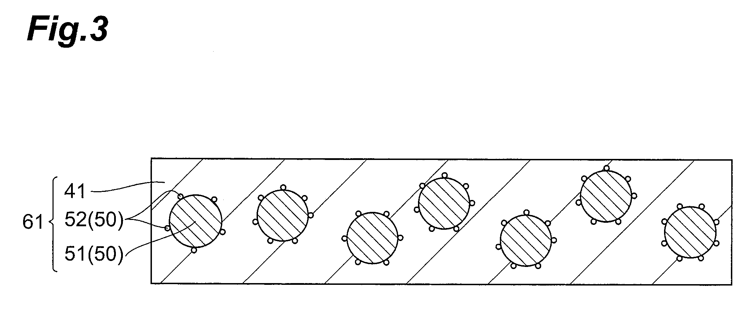

Fig. 3 is a cross-sectional view showing an embodiment of a circuit connecting material film according to the invention. The circuit connecting material film 61 of this embodiment is provided with a film-like insulating member 41 made of the aforementioned adhesive composition, and covered particles 50. The circuit connecting material film 61 is obtained by forming a film of the aforementioned circuit connecting material.

Including a film-forming material in the circuit connecting material will help prevent problems such as tearing, cracking or sticking of the circuit connecting material, and thus facilitate handling of the circuit connecting material under ordinary conditions (ordinary temperature and pressure). Also, the pot life is improved if the circuit connecting material film 61 is divided into two or more layers including a layer containing a curing agent that generates free radicals upon heating and a layer comprising covered particles 50.

### <Film-forming material>

A film-forming material is a material which, when a liquid substance is solidified as a structural composition and formed into a film, facilitates handling of the film and confers mechanical properties that prevent tearing, cracking or sticking, thereby permitting it to be handled as a film under ordinary conditions (ordinary temperature and pressure). As film-forming materials there may be mentioned phenoxy resins, polyvinyl formal resins, polystyrene resins, polyvinyl butyral resins, polyester resins, polyamide resins, xylene resins, polyurethane resins and the like. Phenoxy resins are preferred among these because of their excellent adhesion, compatibility, heat resistance and mechanical strength.

A phenoxy resin is a resin obtained either by reacting a bifunctional phenol with an epihalohydrin to a high molecular mass, or by polyaddition of a bifunctional epoxy resin and a bifunctional phenol. The phenoxy resin may be obtained, for example, by reaction of 1 mole of a bifunctional phenol with 0.985 to 1.015 mole of an epihalohydrin in the presence of a catalyst such as an alkali metal hydroxide, in a nonreactive solvent at a temperature of 40 to 120°C. From the standpoint of mechanical and thermal properties of the resin, the phenoxy resin is preferably obtained by polyaddition reaction using an equivalent ratio of the bifunctional epoxy resin and bifunctional phenol resin such that the epoxy/phenol hydroxyl group ratio is 1/0.9 to 1/1.1, with heating at 50 to 200°C in an amide-based, ether-based, ketone-based, lactone-based or alcohol-based organic solvent with a boiling point of 120°C or above, in the presence of a catalyst such as an alkali metal compound, an organic phosphorus-based compound or a cyclic amine-based compound, under conditions for a reacting solid portion of no greater than 50 parts by weight.

As bifunctional epoxy resins there may be mentioned such as bisphenol-A epoxy resins, bisphenol-F epoxy resins, bisphenol-AD epoxy resins, bisphenol-S epoxy resins, and the like. A bifunctional phenol is a compound having two phenolic hydroxyl groups. As examples of such bifunctional phenols there may be mentioned bisphenols such as bisphenol-A, bisphenol-F, bisphenol-AD and bisphenol-S.

The phenoxy resin preferably has a molecular structure derived from a polycyclic aromatic compound in the molecule. This will yield a circuit connecting material with excellent adhesion, compatibility, heat resistance and mechanical strength.

As examples of polycyclic aromatic compounds there may be mentioned dihydroxy compounds such as naphthalene, biphenyl, acenaphthene, fluorene, dibenzofuran, anthracene and phenanthrene. The polycyclic aromatic compound is preferably fluorene. The polycyclic aromatic compound is most preferably 9,9'-bis(4-hydroxyphenyl)fluorene.

The phenoxy resin may also be modified with radical polymerizing functional groups. The phenoxy resin may be a single type or a mixture of two or more types.

### <Other components>

The circuit connecting material of this embodiment may also contain a polymer or copolymer comprising a monomer component which is one or more selected from the group comprising acrylic acid, acrylic acid esters, methacrylic acid esters and acrylonitrile. From the standpoint of superior stress relaxation, it is preferred to also use a copolymer-based acrylic rubber comprising glycidyl acrylate or glycidyl methacrylate containing a glycidyl ether group. The molecular weight (weight-average molecular weight) of the acrylic rubber is preferably 200,000 or greater from the viewpoint of increasing the cohesive strength of the adhesive.

The circuit connecting material of this embodiment may also include fillers, softeners, accelerators, age inhibitors, flame retardants, pigments, thixotropic agents, coupling agents, phenol resins, melamine resins, isocyanate resins and the like.

A filler is preferably included in the circuit connecting material to improve the connection reliability. The filler used may be any one with a maximum size that is less than the mean particle size of the conductive particles 51. The filler content is preferably 5 to 60 parts by volume with respect to 100 parts by volume of the adhesive composition. If the content is greater than 60 parts by volume, the effect of improved connection reliability will tend to be saturated, while if it is less than 5 parts by volume the effect of addition of the filler will tend to be insufficiently exhibited.

Compounds containing ketimine, vinyl groups, acryl groups, amino groups, epoxy groups or isocyanate groups are preferred for improved adhesion as coupling agents.

Specifically, as amino group-containing silane coupling agents there may be mentioned such as N-β(aminoethyl)γ-aminopropyltrimethoxysilane, N-β(aminoethyl)γ-aminopropylmethyldimethoxysilane, γ-aminopropyltriethoxysilane, N-phenyl-γ-aminopropyltrimethoxysilane and the like. As ketimine-containing silane coupling agents there may be mentioned those obtained by reaction of ketone compounds such as acetone, methyl ethyl ketone and methyl isobutyl ketone with the aforementioned amino group-containing silane coupling agents.

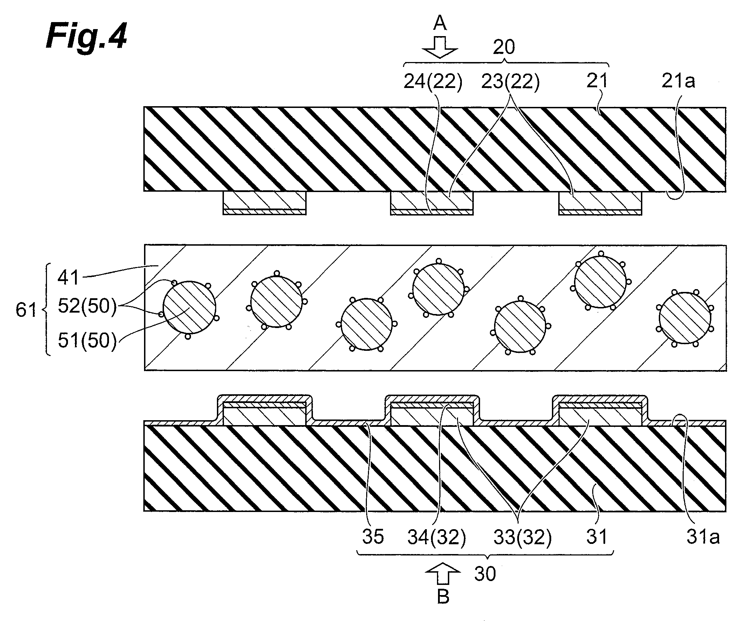

A process for fabrication of the aforementioned connection structure 10 will now be explained with reference to Figs. 1, 3 and 4. Fig. 3 is a cross-sectional view showing a circuit connecting material film used for fabrication of a connection structure 10. Fig. 4 is a cross-sectional view showing a step in a fabrication process for the connection structure 10.

### (Process for fabrication of circuit member connection structure)

First, circuit members 20,30 are prepared. The circuit connecting material film 61 that has been formed into a film is also prepared separately (see Fig. 3). Next, the circuit connecting material film 61 obtained by forming the circuit connecting material into a film is situated between the circuit member 20 and circuit member 30. In other words, the circuit connecting material film 61 is situated between the circuit member 20 and circuit member 30 with the circuit electrode 22 and circuit electrode 32 opposing each other. Specifically, for example, the circuit connecting material film 61 is placed on the circuit member 30 and the circuit member 20 is then placed over the circuit connecting material film 61. Here, the circuit member 20 and circuit member 30 are situated so that the circuit electrode 22 and circuit electrode 32 are opposing each other. The circuit connecting material film 61 is easy to manage since it is in the form of a film. Thus, the circuit connecting material film 61 may be easily situated between the circuit members 20,30 in order to facilitate the operation of connecting the circuit members 20,30.

Next, the circuit connecting material film 61 is heated and pressed through the circuit members 20,30 in the direction of the arrows A and B in Fig. 4 for curing treatment (see Fig. 4), to form a circuit connecting member 60 between the circuit members 20,30 (see Fig. 1). The curing treatment may be carried out by an ordinary method, which may be appropriately selected depending on the adhesive composition. During the heating and pressing, light may be irradiated from one side of the circuit members 20,30 for positioning of the circuit electrodes 22,23.

Fabricating the connection structure 10 in this manner can adequately lower and stabilize the connection resistance between the opposing circuit electrodes 22,32, while yielding a connection structure 10 with a satisfactorily improved insulating property between the adjacent circuit electrodes 22,32.

### [Second embodiment]

### (Circuit member connection structure)

The connection structure 10 of this embodiment is provided with a mutually opposing circuit member 20 (first circuit member) and circuit member 30 (second circuit member), with a circuit connecting member 60 connecting between the circuit member 20 and circuit member 30.

The circuit members 20,30 preferably have the same construction and are comprising the same materials as the first embodiment.

The circuit connecting member 60 is situated between the main surface 21a of the circuit board 21 and the main surface 31a of the circuit board 31, and it connects together the circuit members 20,30 with the circuit electrodes 22,32 opposing each other. The circuit connecting member 60 is also provided with an insulating member 40 and covered particles 50 comprising conductive particles 51 with portions of their surfaces 51a covered by insulating fine particles 52. In this embodiment, the specific gravity of the covered particles 50 is 97/100 to 99/100 of the specific gravity of the conductive particles 51. The circuit electrode 22 and circuit electrode 32 are electrically connected via the covered particles 50.

Here, the circuit connecting member 60 comprises a cured product of the circuit connecting material described hereunder, and therefore the connection structure 10 can exhibit adequately reduced connection resistance between the opposing circuit electrodes 22,32 as well as satisfactory improvement in the insulating property between the adjacent circuit electrodes 22,32.

### (Circuit connecting material)

The circuit connecting material of this embodiment comprises an adhesive composition and covered particles 50. If this circuit connecting material is situated between the circuit members 20,30 and heated and pressed through the circuit members 20,30 for curing treatment to obtain the connection structure 10, the obtained connection structure 10 will exhibit adequately reduced connection resistance between the opposing circuit electrodes 22,32 and satisfactory improvement in the insulating property between the adjacent circuit electrodes 22,32

### <Adhesive composition>

Examples for the adhesive composition include the same adhesive compositions mentioned for the first embodiment.

### <Covered particles>

The covered particles 50 comprise conductive particles 51 with portions of their surfaces 51a covered by insulating fine particles 52. The specific gravity of the covered particles 50 of this embodiment is 97/100 to 99/100 of the specific gravity of the conductive particles 51.

If the specific gravity of the covered particles 50 is less than 97/100 of the specific gravity of the conductive particles 51, the insulating fine particles 52 will be excessively covering the conductive particles 51. This will result in increased connection resistance of the conductive particles 51 in the thickness direction of the circuit boards 21,31 when the opposing circuit electrodes 22,32 are connected together. On the other hand, if the specific gravity of the covered particles 50 exceeds 99/100 of the specific gravity of the conductive particles 51, the conductive particles 51 will not be adequately covered by the insulating fine particles 52. The insulating property between adjacent circuit electrodes 22,32, i.e. the insulating property in the plane of the circuit boards 21,31, will therefore be unsatisfactory.

In the covered particles 50, it is preferred for 5 to 60% of the surfaces 51a of the conductive particles 51 to be covered by the insulating fine particles 52.

If less than 5% of the surfaces 51a of the conductive particles 51 is covered, the conductive particles 51 will not be adequately covered by the insulating fine particles 52, and the insulating property between adjacent circuit electrodes 22,32, i.e. the insulating property in the plane of the circuit boards 21,31, will therefore be unsatisfactory as compared to when no less than 5% of the surfaces 51a is covered. On the other hand, if more than 60% of the surfaces 51a of the conductive particles 51 is covered the insulating fine particles 52 will be excessively covering the conductive particles 51, and therefore electrical resistance in the thickness direction of the circuit boards 21,31 will be increased when the opposing circuit electrodes 22,32 are connected together, as compared to when not greater than 60% of the surfaces 51a of the conductive particles 51 is covered.

The conductive particles 51 and insulating fine particles 52 preferably have the same construction and are comprising the same materials as for the first embodiment.

### <Film-forming material>

The circuit connecting material of this embodiment also preferably contains the same film-forming material as the first embodiment. This will facilitate working of the circuit connecting material into a film form, in order to obtain a circuit connecting material film.

### <Other components>

The circuit connecting material of this embodiment also preferably contains the same other added components as the first embodiment.

### (Process for fabrication of circuit member connection structure)

The process for fabrication of the circuit member connection structure of this embodiment is preferably the same process for fabrication of the circuit member connection structure of the first embodiment.

Preferred embodiments of the invention have been described above, but the invention is not limited to those embodiments.

For example, while the first and second embodiments have electrode surface layers 24,34 on both of the circuit electrodes 22,32 of the connection structure 10, optionally only one of the circuit electrodes 22,32 may have an electrode surface layer. Alternatively, both of the circuit electrodes 22,32 may lack an electrode surface layer. That is, although both of the circuit electrodes 22,32 of the first and second embodiments have electrode surface layers 24,34, one or both of the circuit electrodes 22,32 may optionally lack an electrode surface layer.

Also, although the circuit member 30 of the connection structure 10 has a board surface layer 35 in the first and second embodiments, optionally only the circuit member 20 may have a board surface layer. Alternatively, both of the circuit members 20,30 may have board surface layers. Also alternatively, both of the circuit members 20,30 may lack board surface layers. That is, although the circuit member 30 of the first and second embodiments has a board surface layer 35, either one or both of the circuit electrodes 20,30 may have a board surface layer.

Also, while the connection structure 10 of the first and second embodiments was fabricated using the circuit connecting material film 61, there is no limitation to the circuit connecting material film 61, and optionally there may be used a circuit connecting material without a film-forming material. In this case as well, dissolving the circuit connecting material in a solvent and coating and drying the solution on either or both of the circuit members 20,30 can form a circuit connecting material between the circuit members 20,30.

Moreover, although the circuit connecting material of the first and second embodiments comprised conductive particles 51, it may optionally be produced without conductive particles 51. In this case, electrical connection can be achieved by direct contact between the opposing circuit electrodes 22,32. However, including conductive particles 51 will yield a more stable electrical connection than when conductive particles 51 are not included.

### Examples

The present invention will now be explained in greater detail using examples, with the understanding that the invention is in no way limited to these examples.

### (Example 1)

### (1) Preparation of covered particles

First, the surfaces of crosslinked polystyrene particles (PSt) with a mean particle size of 5 µm were electroless plated with a nickel layer to a thickness of 0.2 µm, and then a gold layer with a thickness of 0.04 µm was formed on the outside of the nickel layer to obtain plated plastic particles (PSt-M) corresponding to conductive particles 51. Portions of the surfaces of the plated plastic particles were covered with a methyl methacrylate polymer, specifically polymethyl methacrylate (PMMA), corresponding to insulating fine particles 52, to obtain covered particles A with a mean particle size of 5.2 µm covered with insulating fine particles with a mean particle size of 0.2 µm. The covered particles A had 20% of the conductive particle surfaces covered, such that the specific gravity after covering was 98/100 of the specific gravity before covering. The mean particle size was calculated from the measured value obtained by observation with a scanning electron microscope.

### (2) Pyrolysis gas chromatography measurement

First, pyrolysis gas chromatography measurement was performed to draw a calibration curve for mass ratio A (ratio of the mass of the insulating fine particles with respect to the mass of the conductive particles). For the measurement results, the peak area I_{St} for styrene (St) was used as the thermal decomposition peak of the plated plastic particles (PSt-M). Also, the peak area I_{MMA} for methyl methacrylate (MMA) was used as the thermal decomposition peak of polymethyl methacrylate (PMMA). The peak area ratio (I_{MMA}/Iₛₜ) was then calculated.

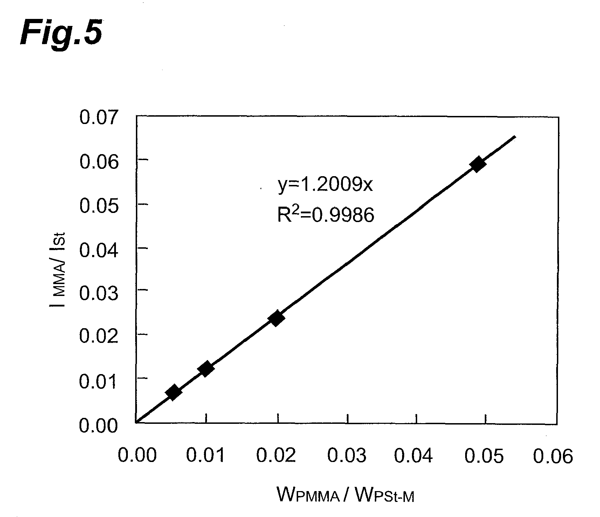

The mass W_{PSt-M} of the plated plastic particles (PSt-M) corresponds to the mass of the conductive particles 51, and the mass W_{PMMA} of polymethyl methacrylate (PMMA) corresponds to the mass of the insulating fine particles 52. The mass ratio A (W_{PMMA}/W_{PSt-M}) was then calculated. A calibration curve as shown in Fig. 5 was drawn for the relationship between the peak area ratio (I_{MMA}/I_{St}) and the mass ratio A (W_{PMMA}/W_{PSt-M}). The calibration curve in Fig. 5 had good linearity.

Next, pyrolysis gas chromatography measurement was performed to draw a calibration curve for mass ratio B (ratio of the mass of the insulating fine particles with respect to the mass of the nuclei). For the measurement results, the peak area I_{St} for styrene (St) was used as the thermal decomposition peak of the crosslinked polystyrene particles (PSt). Also, the peak area I_{MMA} for methyl methacrylate (MMA) was used as the thermal decomposition peak of polymethyl methacrylate (PMMA). The peak area ratio (I_{MMA}/I_{St}) was then calculated.

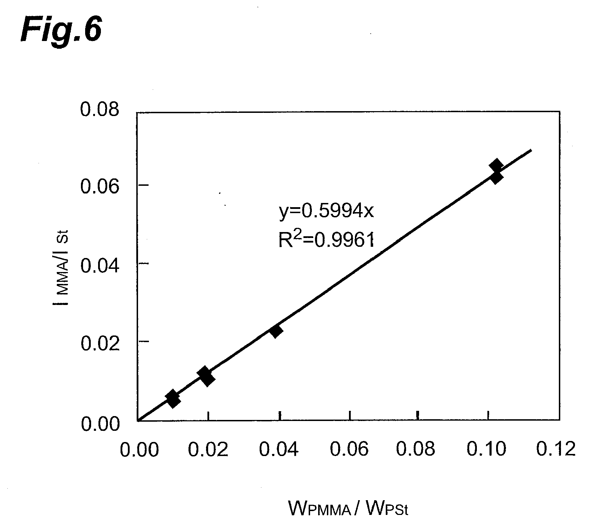

The mass W_{PMMA} of polymethyl methacrylate (PMMA) corresponds to the mass of the insulating fine particles 52, and the mass W_{PSt} of the crosslinked polystyrene particles (PSt) corresponds to the mass of the nuclei 51x. The mass ratio B (W_{PMMA}/W_{PSt}) was then calculated. A calibration curve as shown in Fig. 6 was drawn for the relationship between the peak area ratio (I_{MMA}/I_{St}) and the mass ratio B (W_{PMMA}/W_{PSt}). The calibration curve in Fig. 6 had good linearity.

For the covered particles A, pyrolysis gas chromatography measurement was performed under the measuring conditions shown in Table 1, and the peak area ratio (I_{MMA}/I_{St}) was measured. Based on this peak area ratio, calculation of the mass ratio A from the calibration curve of Fig. 5 yielded a mass ratio A of 9/1000, and calculation of the mass ratio B from the calibration curve of Fig. 6 yielded a mass ratio B of 29/1000 (see Table 2).

**[Table 1]**

| | **Model or measurement conditions** |
|---|---|
| **Thermal decomposition apparatus** | **Curie Point Pyrolyzer Model JHP-5, Japan Analytical Industry Co., Ltd.** |
| **Gas chromatography** | **Model 6890N by Agilent Co., Ltd.** |
| **Detector** | **Hydrogen flame ionization detector** |
| **Column** | **HP-5MS Capillary Column (inner diameter: 0.25 mm, length: 30 m) by Agilent Co., Ltd.** |
| **Column temperature increase conditions** | **Temperature increase from 50°C to 300°C at 10°C/min, followed by holding for 10 min.** |
| **Carrier gas** | **Helium (column flow rate: 1 ml/min)** |
| **Injection method** | **Split injection method (split ratio = 50:1)** |

**[Table 2]**

| | **Example 1 (Covered particles A)** | **Example 2 (Covered particles B)** | **Example 3 (Covered particles C)** | **Comp. Ex. 1 (Conductive particles)** | **Comp. Ex. 2 (Covered particles E)** |
|---|---|---|---|---|---|
| **Mass ratio A** | **9/1000** | **18/1000** | **11/1000** | **0/1000** | **30/1000** |
| **Mass ratio B** | **29/1000** | **58/1000** | **34/1000** | **0/1000** | **101/1000** |

### (3) Fabrication of circuit connecting material

First, a phenoxy resin with a glass transition temperature of 80°C was synthesized from a bisphenol-A epoxy resin and bisphenol A. A 50 g portion of the phenoxy resin was dissolved in a mixed solvent of toluene (boiling point: 110.6°C, SP value = 8.90)/ethyl acetate (boiling point: 77.1 °C, SP value = 9.10) in a weight ratio of 50/50 to obtain a solution with a solid portion of 40 wt%. A solution was then prepared comprising 60 g of the phenoxy resin, 39 g of dicyclopentenyldialcohol diacrylate, 1 g of a phosphoric acid ester-type acrylate and 5 g of t-hexylperoxy-2-ethyl hexanonate, as solid weight ratio.

The covered particles A were then added and dispersed at 5 vol% in the above solution to prepare a solution. A coating apparatus was used to coat the solution onto an 80 µm-thick PET (polyethylene terephthalate) film which had been surface treated on one side, and it was hot-air dried at 70°C for 10 minutes to obtain a first film-like material with a thickness of 10 µm on the PET film.

Another solution was also prepared with 60 g of phenoxy resin, 39 g of dicyclopentenyldialcohol diacrylate, 1 g of a phosphoric acid ester acrylate and 5 g of t-hexyl peroxy-2-ethylhexanonate as solid weight ratio. A coating apparatus was used to coat the solution onto an 80 µm-thick PET (polyethylene terephthalate) film which had been surface treated on one side, and it was hot-air dried at 70°C for 10 minutes to obtain a second film-like material made of an adhesive composition with a thickness of 10 µm on the PET film.

The first film-like material and second film-like material were attached with a laminator to obtain a circuit connecting material film with a bilayer structure.

### (4) Fabrication of circuit member connection structure

First, an IC chip bearing an array of gold bumps with a bump area of 50 µm x 50 µm, a pitch of 100 µm and a height of 20 µm was prepared as a first circuit member. Next, an ITO board (surface resistance < 20 Ω/square) having an indium tin oxide (ITO) circuit vapor deposited on a glass panel with a thickness of 1.1 mm was prepared as a second circuit member.

The aforementioned circuit connecting material film was placed between the IC chip and ITO board, and then the IC chip, circuit connecting material film and ITO board were sandwiched between glass quartz and a pressing head for heating and pressing at 200°C, 100 MPa for 10 seconds. The IC chip and ITO board were thus connected through the circuit connecting material film. Here, one of the adhesive sides of the circuit connecting material film was previously attached to the ITO board by heating and pressing at 70°C, 0.5 MPa for 5 seconds. Then, the PET film was released and the other adhesive side of the circuit connecting material film was connected to the IC chip. The circuit member connection structure A was fabricated in this manner.

### (Example 2)

### (1) Preparation of covered particles

First, the surfaces of crosslinked polystyrene particles with a mean particle size of 5 µm were electroless plated with a nickel layer to a thickness of 0.2 µm, and then a gold layer with a thickness of 0.04 µm was formed on the outside of the nickel layer to obtain plated plastic particles (PSt-M) corresponding to conductive particles 51. Portions of the surfaces of the plated plastic particles were covered with polymethyl methacrylate (PMMA), corresponding to insulating fine particles 52, to obtain covered particles B with a mean particle size of 5.2 µm covered with insulating fine particles having a mean particle size of 0.2 µm. The covered particles B had 40% of the conductive particle surfaces covered, and the conductive particles were covered with the insulating fine particles in such a manner that the specific gravity after covering was 97/100 of the specific gravity before covering. The mean particle size was calculated from the measured value obtained by observation with a scanning electron microscope. The covering ratio was measured in the same manner as Example 1.

### (2) Pyrolysis gas chromatography measurement

For the covered particles B, pyrolysis gas chromatography measurement was performed under the measuring conditions shown in Table 1. Calculation of the mass ratio A from the calibration curve of Fig. 5 yielded a mass ratio A of 18/1000, and calculation of the mass ratio B from the calibration curve of Fig. 6 yielded a mass ratio B of 58/1000 (see Table 2).

### (3) Fabrication of circuit connecting material

First, a phenoxy resin with a glass transition temperature of 80°C was synthesized from a bisphenol-A epoxy resin and 9,9'-bis(4-hydroxyphenyl)fluorene. A 50 g portion of the phenoxy resin was dissolved in a mixed solvent of toluene (boiling point: 110.6°C, SP value = 8.90)/ethyl acetate (boiling point: 77.1 °C, SP value = 9.10) in a weight ratio of 50/50 to obtain a solution with a solid portion of 40 wt%. A solution was then prepared comprising 60 g of the phenoxy resin, 39 g of dicyclopentenyldialcohol diacrylate, 1 g of a phosphoric acid ester-type acrylate and 5 g of t-hexylperoxy-2-ethyl hexanonate, as solid weight ratio.

The covered particles B were then added and dispersed at 5 vol% in the above solution to prepare a solution. A coating apparatus was used to coat the solution onto an 80 µm-thick PET (polyethylene terephthalate) film which had been surface treated on one side, and it was hot-air dried at 70°C for 10 minutes to obtain a first film-like material with a thickness of 10 µm on the PET film.

Another solution was also prepared with 60 g of phenoxy resin, 39 g of dicyclopentenyldialcohol diacrylate, 1 g of a phosphoric acid ester acrylate and 5 g of t-hexylperoxy-2-ethyl hexanonate as solid weight ratio. A coating apparatus was used to coat the solution onto an 80 µm-thick PET (polyethylene terephthalate) film which had been surface treated on one side, and it was hot-air dried at 70°C for 10 minutes to obtain a second film-like material made of an adhesive composition with a thickness of 10 µm on the PET film.

The first film-like material and second film-like material were attached with a laminator to obtain a circuit connecting material film with a bilayer structure.

### (4) Fabrication of circuit member connection structure

The aforementioned circuit connecting material film was used to fabricate a circuit member connection structure B in the same manner as Example 1.

### (Example 3)

### (1) Preparation of covered particles

As covered particles C there were used AUL-704 GD by Sekisui Chemical Co., Ltd. The nuclei 51x of the covered particles C were comprising a polyacrylic acid ester-based plastic, and the mean particle size of the conductive particles 51 was 4 µm. The insulating fine particles 52 were comprising polymethyl methacrylate (PMMA), and their mean particle size was 0.2 µm.

### (2) Pyrolysis gas chromatography measurement

First, pyrolysis gas chromatography measurement was performed to draw a calibration curve for mass ratio A. For the measurement, AUL-704(PAc-M) by Sekisui Chemical Co., Ltd. were used as conductive particles 51 with nuclei 51y comprising a polyacrylic acid ester-based plastic.

For the measurement results, the acrylic acid ester (Ac) peak area I_{Ac} was used as the peak of the thermal decomposition component of AUL-704(PAc-M). Also, the peak area I_{MMA} for methyl methacrylate (MMA) was used as the thermal decomposition peak of polymethyl methacrylate (PMMA). The peak area ratio (I_{MMA}/I_{St}) was then calculated.

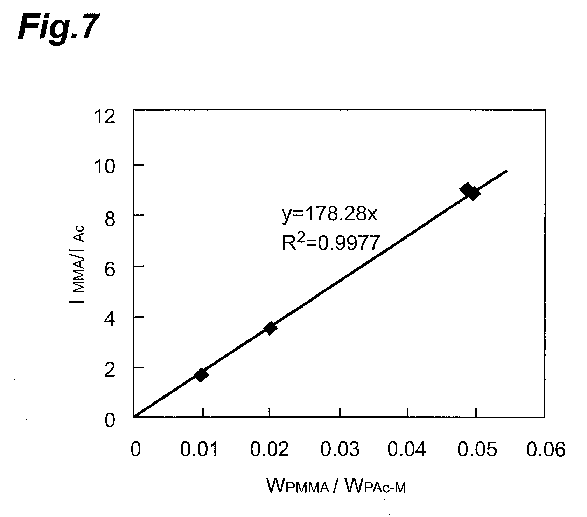

The mass WPAc-M of AUL-704(PAc-M) corresponds to the mass of the conductive particles 51, and the mass W_{PMMA} of the polymethyl methacrylate (PMMA) corresponds to the mass of the insulating fine particles 52. The mass ratio A (W_{PMMA}/W_{PAc-M}) was then calculated. A calibration curve as shown in Fig. 7 was drawn for the relationship between the peak area ratio (I_{MMA}/I_{St}) and the mass ratio A (W_{PMMA}/W_{PAc-M}). The calibration curve in Fig. 7 had good linearity.

Next, pyrolysis gas chromatography measurement was performed to draw a calibration curve for mass ratio B. For the measurement, LP-704(PAc) by Sekisui Chemical Co., Ltd. were used as the polyacrylic acid ester particles.

For the measurement results, the acrylic acid ester (Ac) peak area I_{Ac} was used as the peak of the thermal decomposition component of LP-704(PAc). Also, the peak area I_{MMA} for methyl methacrylate (MMA) was used as the thermal decomposition peak for polymethyl methacrylate (PMMA). The peak area ratio (I_{MMA}/I_{Ac}) was then calculated.

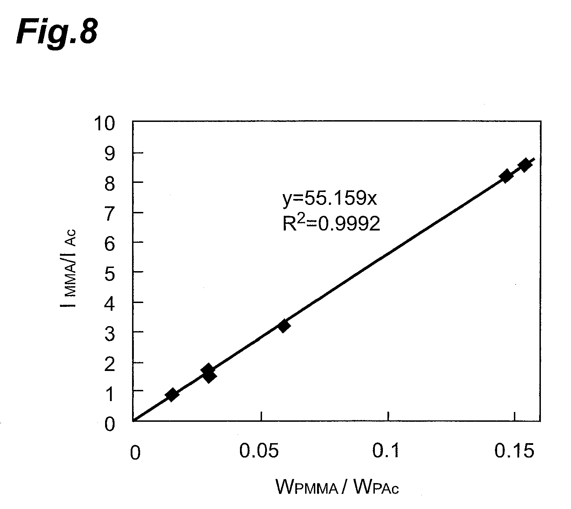

The mass W_{PMMA} of polymethyl methacrylate (PMMA) corresponds to the mass of the insulating fine particles 52, and the mass WPAc of the LP-704(PAc) corresponds to the mass of the nuclei 51x. The mass ratio B (W_{PMMA}/W_{PAc}) was then calculated. A calibration curve as shown in Fig. 8 was drawn for the relationship between the peak area ratio (I_{MMA}/I_{Ac}) and the mass ratio B (W_{PMMA}/W_{PAc}). The calibration curve in Fig. 8 had good linearity.

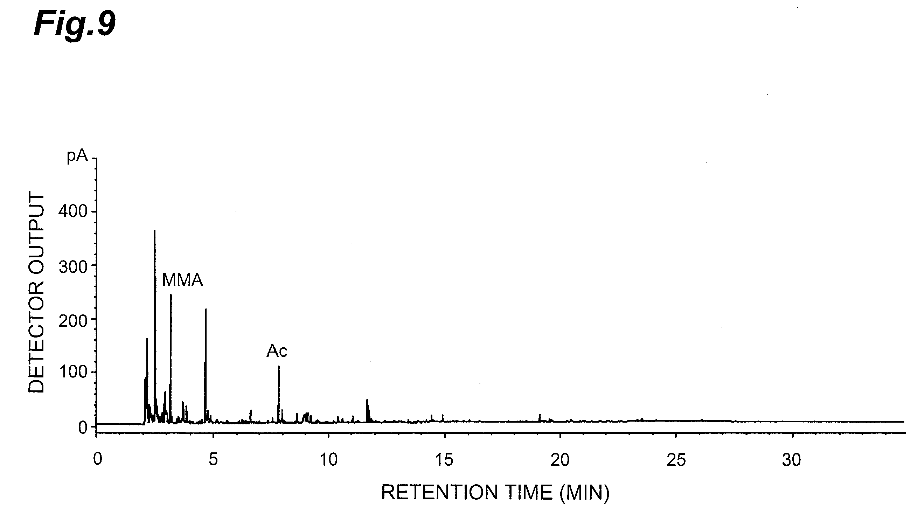

For the covered particles C, pyrolysis gas chromatography measurement was performed under the measuring conditions shown in Table 1, yielding the pyrogram shown in Fig. 9. The peak area ratio (I_{MMA}/I_{Ac}) for the acrylic acid ester (Ac) and methyl methacrylate (MMA) was 1.90. Using this value, calculation of the mass ratio A from the calibration curve of Fig. 7 yielded a mass ratio A of 11/1000, and calculation of the mass ratio B from the calibration curve of Fig. 8 yielded a mass ratio B of 34/1000 (see Table 2).

### (3) Fabrication of circuit connecting material

A circuit connecting material film with a bilayer structure was obtained in the same manner as Example 1, except that covered particles C were used instead of the covered particles A in Example 1.

### (4) Fabrication of circuit member connection structure

The aforementioned circuit connecting material film was used to fabricate a circuit member connection structure C in the same manner as Example 1.

### (Comparative Example 1)

### (1) Preparation of conductive particles

There were used conductive particles which were not covered on the surface with insulating fine particles. That is, the covering ratio of the conductive particles was 0%.

### (2) Pyrolysis gas chromatography measurement

The results of calculating the mass ratio A and mass ratio B are shown in Table 2.

### (3) Fabrication of circuit connecting material

A circuit connecting material film with a bilayer structure was obtained in the same manner as Example 1, except that conductive particles not covered with insulating fine particles were used instead of the covered particles A in Example 1.

### (4) Fabrication of circuit member connection structure

The aforementioned circuit connecting material film was used to fabricate a circuit member connection structure D in the same manner as Example 1.

### (Comparative Example 2)

### (1) Preparation of covered particles

First, the surfaces of crosslinked polystyrene particles (Pst) with a mean particle size of 5 µm were electroless plated with a nickel layer to a thickness of 0.2 µm, and then a gold layer with a thickness of 0.04 µm was formed on the outside of the nickel layer to obtain plated plastic particles (PSt-M). Portions of the surfaces of the plated plastic particles were covered with polymethyl methacrylate (PMMA) to obtain covered particles E with a mean particle size of 5.2 µm covered with insulating fine particles having a mean particle size of 0.2 µm. The mean particle size was calculated from the measured value obtained by observation with a scanning electron microscope.

### (2) Pyrolysis gas chromatography measurement

For the covered particles E, pyrolysis gas chromatography measurement was performed under the measuring conditions shown in Table 1. Calculation of the mass ratio A from the calibration curve of Fig. 5 yielded a mass ratio A of 30/1000, and calculation of the mass ratio B from the calibration curve of Fig. 6 yielded a mass ratio B of 101/1000 (see Table 2).

### (3) Fabrication of circuit connecting material

A circuit connecting material film with a bilayer structure was obtained in the same manner as Example 1, except that covered particles E were used instead of the covered particles A in Example 1.

### (4) Fabrication of circuit member connection structure

The aforementioned circuit connecting material film was used to fabricate a circuit member connection structure E in the same manner as Example 1.

### (Measurement of connection resistance between opposing circuit electrodes)

For circuit member connection structures A to E, the initial connection resistance (immediately after connection) and the connection resistance after holding for 500 cycles in a temperature cycling tank at -40°C for 30 minutes and at 100°C for 30 minutes were measured with a multimeter using the two-terminal measuring method. The results are shown in Table 3. Here, "connection resistance" refers to the resistance between the opposing circuit electrodes.

### (Measurement of insulation resistance between adjacent circuit electrodes)

For circuit member connection structures A to E, the insulation resistance after application of a direct-current (DC) voltage of 50 V for 1 minute was measured with a multimeter using the two-terminal measuring method. The results are shown in Table 3. Here, the "insulation resistance" refers to the resistance between adjacent circuit electrodes.

**[Table 3]**

| | | **Example 1 (Connection structure A)** | **Example 2 (Connection structure B)** | **Example 3 (Connection structure C)** | **Comp.Ex. 1 (Connection structure D)** | **Comp.Ex. 2 (Connection structure E)** |
|---|---|---|---|---|---|---|
| **Connection resistance** | **Initial (Ω)** | **<1** | **<1** | **<1** | **<1** | **2** |
| | **After temperature cycling (Ω)** | **<1** | **<1** | **<1** | **<1** | **>20** |
| **Insulation resistance (Ω)** | | **>10**^{**12**} | **>10**^{**12**} | **>10**^{**12**} | **<10**^{**4**} | **>10**^{**12**} |

With the circuit member connection structures A to C of Examples 1 to 3, both the initial and post-temperature cycling connection resistance were sufficiently minimized, while the insulation resistance was satisfactorily increased.

In contrast, with the circuit member connection structure D of Comparative Example 1, the insulation resistance was reduced compared to the connection structures A to C. Also, with the circuit member connection structure E of Comparative Example 2, both the initial and post-temperature cycling connection resistances were higher than the connection structures A to C.

Examples 1 to 3 and Comparative Examples 1 and 2 correspond to the first embodiment. Thus, it was confirmed that when a circuit connecting material of the first embodiment is used for fabrication of a circuit member connection structure, the obtained circuit member connection structure can provide adequately reduced and stabilized connection resistance between opposing circuit electrodes, with satisfactorily improved insulation resistance between adjacent circuit electrodes.

### (Example 4)

First, a phenoxy resin with a glass transition temperature of 80°C was synthesized from a bisphenol-A epoxy resin and bisphenol A. A 50 g portion of the phenoxy resin was dissolved in a mixed solvent of toluene (boiling point: 110.6°C, SP value = 8.90)/ethyl acetate (boiling point: 77.1°C, SP value = 9.10) in a weight ratio of 50/50 to obtain a solution with a solid portion of 40 wt%. The solution was also prepared with 60 g of phenoxy resin, 39 g of dicyclopentenyldialcohol diacrylate, 1 g of a phosphoric acid ester acrylate and 5 g of t-hexylperoxy-2-ethyl hexanonate as solid weight ratio.

Also, insulating fine particles comprising a polymer of a radical polymerizing substance (acrylate monomer) were used for covering of 20% of the surfaces of conductive particles such that the specific gravity after covering was 98/100 of the specific gravity before covering, to obtain covered particles. The conductive particles had a nickel layer with a thickness of 0.2 µm on the surfaces of polystyrene nuclei, and a gold layer with a thickness of 0.04 µm formed on the outside of the nickel layer. The conductive particles used were conductive particles with a mean particle size of 5 µm.

The covered particles were added and dispersed at 5 vol% in the above solution to prepare a solution. A coating apparatus was used to coat the solution onto an 80 µm-thick PET (polyethylene terephthalate) film which had been surface treated on one side, and it was hot-air dried at 70°C for 10 minutes to obtain a first film-like material with a thickness of 10 µm on the PET film.

Another solution was also prepared with 60 g of phenoxy resin, 39 g of dicyclopentenyldialcohol diacrylate, 1 g of a phosphoric acid ester acrylate and 5 g of t-hexylperoxy-2-ethyl hexanonate as solid weight ratio. A coating apparatus was used to coat the solution onto an 80 µm-thick PET (polyethylene terephthalate) film which had been surface treated on one side, and it was hot-air dried at 70°C for 10 minutes to obtain a second film-like material made of an adhesive composition with a thickness of 10 µm on the PET film.

The first film-like material and second film-like material were attached with a laminator to obtain a circuit connecting material film with a bilayer structure.

### (Example 5)

First, a phenoxy resin with a glass transition temperature of 80°C was synthesized from a bisphenol-A epoxy resin and 9,9'-bis(4-hydroxyphenyl)fluorene. A 50 g portion of the phenoxy resin was dissolved in a mixed solvent of toluene (boiling point: 110.6°C, SP value = 8.90)/ethyl acetate (boiling point: 77.1 °C, SP value = 9.10) in a weight ratio of 50/50 to obtain a solution with a solid portion of 40 wt%. A solution was then prepared comprising 60 g of the phenoxy resin, 39 g of dicyclopentenyldialcohol diacrylate, 1 g of a phosphoric acid ester-type acrylate and 5 g of t-hexylperoxy-2-ethyl hexanonate, as solid weight ratio.

Also, insulating fine particles comprising a polymer of a radical polymerizing substance (acrylate monomer) were used for covering of 40% of the surfaces of conductive particles such that the specific gravity after covering was 97/100 of the specific gravity before covering, to obtain covered particles. The conductive particles had a nickel layer with a thickness of 0.2 µm on the surfaces of polystyrene nuclei, and a gold layer with a thickness of 0.04 µm formed on the outside of the nickel layer. The conductive particles used were conductive particles with a mean particle size of 5 µm.

The covered particles were added and dispersed at 5 vol% in the above solution to prepare a solution. A coating apparatus was used to coat the solution onto an 80 µm-thick PET (polyethylene terephthalate) film which had been surface treated on one side, and it was hot-air dried at 70°C for 10 minutes to obtain a first film-like material with a thickness of 10 µm on the PET film.

Another solution was also prepared with 60 g of phenoxy resin, 39 g of dicyclopentenyldialcohol diacrylate, 1 g of a phosphoric acid ester acrylate and 5 g of t-hexylperoxy-2-ethyl hexanonate as solid weight ratio. A coating apparatus was used to coat the solution onto an 80 µm-thick PET (polyethylene terephthalate) film which had been surface treated on one side, and it was hot-air dried at 70°C for 10 minutes to obtain a second film-like material made of an adhesive composition with a thickness of 10 µm on the PET film.

The first film-like material and second film-like material were attached with a laminator to obtain a circuit connecting material film with a bilayer structure.

### (Comparative Example 3)

A circuit connecting material film with a bilayer structure was obtained in the same manner as Example 4, except that conductive particles not covered with insulating fine particles were used instead of the covered particles in Example 4. That is, the covering ratio of the conductive particles was 0%.

### (Comparative Example 4)

A circuit connecting material film with a bilayer structure was obtained in the same manner as Example 4, except that the conductive particles described below were used instead of the covered particles in Example 4.

Insulating fine particles comprising a polymer of a radical polymerizing substance (acrylate monomer) were used for covering of 70% of the surfaces of conductive particles such that the specific gravity after covering was 95/100 of the specific gravity before covering, to obtain covered particles. The conductive particles had a nickel layer with a thickness of 0.2 µm on the surfaces of polystyrene nuclei, and a gold layer with a thickness of 0.04 µm formed on the outside of the nickel layer. The conductive particles used were conductive particles with a mean particle size of 5 µm.

### (Fabrication of circuit member connection structure)

First, an IC chip bearing an array of gold bumps with a bump area of 50 µm x 50 µm, a pitch of 100 µm and a height of 20 µm was prepared as a first circuit member. Next, an ITO board (surface resistance < 20 Ω/square) having an indium tin oxide (ITO) circuit vapor deposited on a glass panel with a thickness of 1.1 mm was prepared as a second circuit member.

The circuit connecting material films of Examples 4 and 5 and Comparative Examples 3 and 4 were each placed between the IC chip and ITO board, and then the IC chip, circuit connecting material film and ITO board were sandwiched between glass quartz and a pressing head for heating and pressing at 200°C, 100 MPa for 10 seconds. The IC chip and ITO board were thus connected through each circuit connecting material film. Here, one of the adhesive sides of the circuit connecting material film was previously attached to the ITO board by heating and pressing at 70°C, 0.5 MPa for 5 seconds. Then, the PET film was released and the other adhesive side of the circuit connecting material film was connected to the IC chip.

Circuit member connection structures F to I were fabricated in this manner. The circuit member connection structures F to I were fabricated using the circuit connecting material films of Examples 4 and 5 and Comparative Examples 3 and 4, respectively.

### (Measurement of specific gravity)

The conductive particles before covering and the covered particles after covering were sampled in an amount of 3.5 cc from each of the circuit connecting material films of Examples 4 and 5 and Comparative Examples 3 and 4, and subjected to measurement of specific gravity using a specific gravimeter (Accupyc 1330-01, Shimadzu Corp.) in a helium atmosphere at room temperature, to determine the specific gravity of the covered particles after covering with respect to the specific gravity of the conductive particles before covering (specific gravity ratio). The results are shown in Table 4.

### (Measurement of connection resistance between opposing circuit electrodes)

For circuit member connection structures F to I, the initial connection resistance (immediately after connection) and the connection resistance after holding for 500 cycles in a temperature cycling tank at -40°C for 30 minutes and at 100°C for 30 minutes were measured with a multimeter using the two-terminal measuring method. The results are shown in Table 5. Here, "connection resistance" refers to the resistance between the opposing circuit electrodes.

### (Measurement of insulation resistance between adjacent circuit electrodes)

For circuit member connection structures F to I, the insulation resistance after application of a direct-current (DC) voltage of 50 V for 1 minute was measured with a multimeter using the two-terminal measuring method. The results are shown in Table 5. Here, the "insulation resistance" refers to the resistance between adjacent circuit electrodes.

**[Table 4]**

| | **Example 4** | **Example 5** | **Comp.Ex. 3** | **Comp.Ex. 4** |
|---|---|---|---|---|
| **Specific gravity ratio before/after covering** | **98/100** | **97/100** | **-** | **95/100** |
| **Covering ratio (%)** | **20** | **40** | **0** | **70** |

**[Table 5]**

| | | **Example 4 (Connection structure F)** | **Example 5 (Connection structure G)** | **Comp.Ex. 3 (Connection structure H)** | **Comp.Ex. 4 (Connection structure I)** |
|---|---|---|---|---|---|
| **Connection resistance** | **Initial (Ω)** | **<1** | **<1** | **<1** | **2** |
| | **After temperature cycling (Ω)** | **<1** | **<1** | **<1** | **>20** |
| **Insulation resistance (Ω)** | | **>10**^{**12**} | **>10**^{**12**} | **<10**^{**4**} | **>10**^{**12**} |

With the circuit member connection structures F and G obtained using the circuit connecting material films of Examples 4 and 5, both the initial and post-temperature cycling connection resistances were sufficiently minimized, while the insulation resistance was satisfactorily increased.

In contrast, with the circuit member connection structure H obtained using the circuit connecting material film of Comparative Example 3, the insulation resistance was reduced compared to the connection structures F and G. Also, with the circuit member connection structure I obtained using the circuit connecting material film of Comparative Example 4, both the initial and post-temperature cycling connection resistances were increased compared to the connection structures F and G.

Examples 4,5 and Comparative Examples 3 and 4 correspond to the second embodiment. Thus, it was confirmed that when a circuit connecting material of the second embodiment is used for fabrication of a circuit member connection structure, the obtained circuit member connection structure can provide adequately reduced connection resistance between opposing circuit electrodes, with satisfactorily improved insulation resistance between adjacent circuit electrodes.

## Claims

1. A circuit connecting material for connection of
a first circuit member having a plurality of first circuit electrodes formed on the main surface of a first circuit board and
a second circuit member having a plurality of second circuit electrodes formed on the main surface of a second circuit board,
with said first and second circuit electrodes opposing each other, the circuit connecting material comprising an adhesive composition and covered particles comprising conductive particles with portions of their surfaces covered by insulating fine particles,
wherein the mass of said insulating fine particles constitutes 2/1000 to 26/1000 of the mass of said conductive particles.

2. A circuit connecting material for connection of
a first circuit member having a plurality of first circuit electrodes formed on the main surface of a first circuit board and
a second circuit member having a plurality of second circuit electrodes formed on the main surface of a second circuit board,
with said first and second circuit electrodes opposing each other, the circuit connecting material comprising an adhesive composition and covered particles comprising conductive particles with portions of their surfaces covered by insulating fine particles,
wherein said conductive particles have nuclei comprising a polymer, and
the mass of said insulating fine particles constitutes 7/1000 to 86/1000 of the mass of said nuclei.

3. A circuit connecting material for connection of
a first circuit member having a plurality of first circuit electrodes formed on the main surface of a first circuit board and
a second circuit member having a plurality of second circuit electrodes formed on the main surface of a second circuit board,
with said first and second circuit electrodes opposing each other, the circuit connecting material comprising an adhesive composition and covered particles comprising conductive particles with portions of their surfaces covered by insulating fine particles,
wherein the specific gravity of said covered particles is 97/100 to 99/100 of the specific gravity of said conductive particles.

4. A circuit connecting material according to claim 3, wherein in said covered particles, 5 to 60% of the surfaces of said conductive particles are covered by said insulating fine particles

5. A circuit connecting material according to any one of claims 1 to 4, wherein the mean particle size of said insulating fine particles is 1/40 to 1/10 of the mean particle size of said conductive particles.

6. A circuit connecting material according to any one of claims 1 to 5, wherein said insulating fine particles are comprising a polymer of a radical polymerizing substance.

7. A circuit connecting material according to any one of claims 1 to 6, wherein said adhesive composition comprises a radical polymerizing substance and a curing agent which generates free radicals in response to heating.

8. A circuit connecting material according to any one of claims 1 to 7, which further comprises a film-forming material comprising a phenoxy resin.

9. A circuit connecting material according to claim 8, wherein said phenoxy resin has a molecular structure derived from a polycyclic aromatic compound in the molecule.

10. A circuit connecting material according to claim 9, wherein said polycyclic aromatic compound is fluorene.

11. A circuit connecting material film comprising a circuit connecting material according to any one of claims 1 to 10 formed into a film.

12. A circuit member connection structure provided with
a first circuit member having a plurality of first circuit electrodes formed on the main surface of a first circuit board,
a second circuit member having a plurality of second circuit electrodes formed on the main surface of a second circuit board,
and a circuit connecting member situated between the main surface of said first circuit board and the main surface of said second circuit board, and connecting said first and second circuit members together with said first and second circuit electrodes opposing each other,
wherein said circuit connecting member is comprising a cured circuit connecting material according to any one of claims 1 to 10,
and said first circuit electrodes and said second circuit electrodes are electrically connected through said covered particles.

13. A circuit member connection structure according to claim 12, wherein, when a direct current voltage of 50 V is applied between adjacent circuit electrodes, the resistance value between said adjacent circuit electrodes is 10⁹Ω or greater.

14. A circuit member connection structure according to claim 12 or 13,
wherein at least one of said first and second circuit members is an IC chip.

15. A circuit member connection structure according to any one of claims 12 to 14, wherein the connection resistance between said first circuit electrodes and said second circuit electrodes is no greater than 1 Ω.

16. A circuit member connection structure according to any one of claims 12 to 15, wherein at least one of said first and second circuit electrodes comprises an electrode surface layer comprising at least one compound selected from the group comprising gold, silver, tin, platinum group metals and indium tin oxide.

17. A circuit member connection structure according to any one of claims 12 to 16, wherein at least one of said first and second circuit members comprises a board surface layer comprising at least one compound selected from the group comprising silicon nitride, silicone compounds and polyimide resins.

18. A process for fabrication of a circuit member connection structure, comprising:
a step of situating a circuit connecting material according to any one of claims 1 to 10 between a first circuit member having a plurality of first circuit electrodes formed on the main surface of a first circuit board and a second circuit member having a plurality of second circuit electrodes formed on the main surface of a second circuit board, with said first circuit electrode and second circuit electrode opposing each other; and
a step of curing said circuit connecting material by heating and pressing.
